# FASCICULE DE BREVET EUROPEEN

(11) **EP 2 781 993 B1**
(45) Date de publication et mention de la délivrance du brevet: **01.08.2018**
(21) Numéro de dépôt: 14151716.9
(22) Date de dépôt: 20.01.2014
(51) Int. Cl.: G06F 3/02, H03K 17/972, H01H 13/70

(54) **Système de dialogue homme-machine**
Mensch-Maschinen-Dialogsystem
Human-Machine Dialog System

(30) Priorité: 22.03.2013 FR 1352582
(43) Date de publication de la demande: 24.09.2014
(73) Titulaire: Schneider Electric Industries SAS, 92500 Rueil-Malmaison (FR)
(72) Inventeur: Benni, Dominique, 16600 Mornac (FR); Chauvet, Francis, 16440 Mouthiers (FR); Guillot, Alain, 16730 Fleac (FR)
(74) Mandataire: Dufresne, Thierry

(56) Documents cités:
- EP-A1- 2 479 646
- WO-A2-2007/048054
- DE-A1- 19 839 811
- DE-B3- 10 304 595
- US-A1- 2004 163 936
- US-A1- 2005 269 196

## Description

### Domaine technique de l'invention

La présente invention se rapporte à un système de dialogue homme-machine. L'invention se rapporte plus particulièrement à un système de dialogue homme-machine modulaire dont l'architecture peut s'adapter facilement à l'application commandée.

### Etat de la technique

Il est connu de la demande de brevet EP2479646 un système de dialogue homme-machine comprenant plusieurs organes de dialogue homme-machine agencés dans un support, de manière amovible et interchangeable. Les organes de dialogue homme-machine sont connectés à une unité centrale par l'intermédiaire d'un bus de communication et d'alimentation. Selon sa fonction, l'organe de dialogue homme-machine comporte par exemple un bouton-poussoir ou un organe de visualisation. L'organe de dialogue homme-machine comporte également des moyens de traitement permettant de surveiller en permanence l'état du bouton-poussoir ou de commander l'allumage ou l'extinction de l'organe de visualisation. Une mémoire centrale ou plusieurs mémoires agencées dans chaque organe permettent de mémoriser l'état de chaque organe de dialogue homme-machine.

L'architecture décrite dans la demande EP2479646 offre une grande modularité en ce que les organes de dialogue homme-machine sont facilement remplaçables, sans aucune configuration particulière. Cependant, cette architecture présente certains inconvénients, parmi lesquels :
- La nécessité d'employer une carte électronique dans chaque organe de dialogue homme-machine,
- La nécessité d'alimenter la carte électronique située dans l'organe de dialogue homme-machine,
- La nécessité de doter les organes de dialogue homme-machine de contacts électriques pour se connecter au bus de communication et d'alimentation.

D'autres systèmes de dialogue homme-machine sont connus des documents US2004/163936, DE19839811 et US2005/269196.

Le but de l'invention est donc de proposer un système de dialogue homme-machine permettant de palier les inconvénients listés ci-dessus, ledit système étant d'un coût modéré et d'une étanchéité améliorée.

### Exposé de l'invention

Ce but est atteint par un système de dialogue homme-machine comprenant :
- un support comportant une pluralité de postes d'accueil identiques, chaque poste d'accueil étant associé à un dispositif universel de dialogue homme-machine, chaque dispositif universel de dialogue homme-machine comprenant au moins un organe de visualisation et un organe capteur,
- une pluralité d'organes modulaires, chaque organe modulaire étant agencé pour se positionner sur un poste d'accueil de manière amovible et interchangeable et comprenant une interface de dialogue homme-machine agencée pour coopérer avec ledit organe de visualisation et/ou ledit organe capteur, ladite pluralité d'organes modulaires comportant un premier organe modulaire positionné sur un premier poste d'accueil et dont l'interface de dialogue homme-machine est une interface de commande et un deuxième organe modulaire positionné à un deuxième poste d'accueil et dont l'interface de dialogue homme-machine est une interface de visualisation,
- une unité centrale de commande agencée pour communiquer sélectivement avec l'organe de visualisation et/ou l'organe capteur de chaque poste d'accueil selon le type d'interface de dialogue homme-machine de l'organe modulaire positionné sur chaque poste d'accueil, ladite unité centrale de commande étant agencée pour recevoir un signal de commande de l'organe capteur du premier poste d'accueil lorsque l'interface de commande du premier organe modulaire est activée et pour envoyer un ordre de commande à l'organe de visualisation du deuxième poste d'accueil pour activer l'interface de visualisation du deuxième organe modulaire.

Avantageusement, l'interface de commande comporte un bouton d'actionnement.

Dans une première variante de réalisation, l'organe capteur comporte un interrupteur à actionnement magnétique. Le bouton d'actionnement porte alors au moins un aimant permanent actionnable en mouvement pour agir sur l'interrupteur à actionnement magnétique.

Dans une deuxième variante de réalisation, l'organe capteur comporte un interrupteur à actionnement mécanique. Le bouton d'actionnement comporte alors un élément d'actionnement agencé pour coopérer avec l'interrupteur à actionnement mécanique.

Dans une autre variante de réalisation, l'organe capteur est à effet capacitif, inductif, optique ou résistif.

Avantageusement, le support comporte des moyens de fixation sur une paroi et ces moyens de fixation comportent deux orifices destinés à recevoir chacun une vis de fixation.

Avantageusement, le système comporte une unité centrale de commande et un câble reliant ladite unité centrale de commande aux dispositifs universels de dialogue homme-machine, ladite unité centrale de commande étant agencée pour alimenter chaque dispositif universel de dialogue homme-machine et échanger des signaux avec chaque dispositif universel de dialogue homme-machine.

Dans une première variante de réalisation, les dispositifs universels de dialogue homme-machine sont connectés à l'unité centrale par une liaison multipoints en employant un bus de communication et d'alimentation.

Selon une autre variante de réalisation, les dispositifs universels de dialogue homme-machine sont connectés à l'unité centrale par une liaison point à point.

Selon une autre particularité, chaque organe modulaire comporte une étiquette électronique mémorisant le type d'interface de dialogue homme-machine de l'organe modulaire auquel elle est associée. Le système peut alors comporter une station de lecture des étiquettes électroniques qui sont intégrées dans chaque organe modulaire, ladite station de lecture comportant une antenne agencée à l'intérieur du support.

Selon une variante de réalisation, le système peut comporter un module de communication sans-fil agencé pour échanger des données avec l'unité centrale de commande via une liaison sans-fil.

Avantageusement, les postes d'accueil sont agencés de manière contigüe sur le support.

Selon une première variante de réalisation, les organes modulaires sont solidarisés au support à l'aide d'un capot rapporté sur le support.

Selon une autre variante de réalisation, les organes modulaires sont solidarisés au support en employant des moyens d'encliquetage.

Avantageusement, chaque organe modulaire comporte un boîtier de forme carrée sur lequel est montée ladite interface de dialogue homme-machine.

### Brève description des figures

D'autres caractéristiques et avantages vont apparaître dans la description détaillée qui suit faite en regard des dessins annexés dans lesquels :
- la figure 1 représente, vu en éclaté, le système de dialogue homme-machine de l'invention,
- la figure 2 représente, vu en perspective et monté sur une paroi, le système de dialogue homme-machine de l'invention,
- la figure 3 représente, vu de dessus, le système de dialogue homme-machine de l'invention,
- les figures 4A et 4B représentent, vu en coupe longitudinale partielle, le système de dialogue homme-machine de l'invention, selon deux modes de réalisation distincts,
- la figure 5 représente un organe modulaire employé dans le système de dialogue homme-machine de l'invention.

### Description détaillée d'au moins un mode de réalisation

La description suivante décrit des aspects différents servant à réaliser l'invention. Quelle que soit la formulation utilisée par la description suivante, l'invention même n'est définie que par l'étendue des revendications.

L'invention concerne un système 1 de dialogue homme-machine comportant une pluralité d'organes de dialogue homme-machine.

De manière connue, un organe de dialogue homme-machine, par exemple de type bouton-poussoir, bouton tournant ou voyant lumineux, se compose de :
- un organe fonctionnel réalisant une fonction de commutation et/ou de visualisation,
- une interface de dialogue homme-machine comprenant une interface de commande sur laquelle agit un utilisateur pour réaliser la fonction de commutation et/ou une interface de visualisation renvoyant une information de visualisation réalisée par l'organe fonctionnel de visualisation.

Par organe fonctionnel à fonction de commutation, on entend les éléments qui permettent de remplir la fonction de l'organe de dialogue homme-machine. Cela inclut tout organe capteur, par exemple à actionnement mécanique ou magnétique, à effet capacitif, inductif, optique ou résistif. Par organe fonctionnel à fonction de visualisation, on entend tout organe de visualisation, tel que par exemple une diode électroluminescente ou un système RVB (Rouge Vert Bleu). La diode électroluminescente pourra être de couleur blanche, la couleur de l'organe de dialogue homme-machine étant réalisée par l'interface de dialogue homme-machine. Le système RVB est piloté en couleur et en intensité par une unité de commande électronique.

Par interface de commande on entend par exemple un bouton d'actionnement de type bouton-poussoir, bouton tournant à au moins deux positions et par interface de visualisation, on entend par exemple un cabochon coloré ou une plaque transparente colorée.

Bien entendu, certains organes de dialogue homme-machine comportent à la fois une interface de commande et une interface de visualisation. C'est par exemple le cas des boutons-poussoirs lumineux.

L'invention consiste à dissocier l'organe fonctionnel de son interface de dialogue homme-machine en proposant une solution permettant à un utilisateur de configurer son système en choisissant l'interface de dialogue homme-machine qu'il souhaite utiliser sans avoir à toucher à l'organe fonctionnel. En employant un dispositif universel de dialogue homme-machine réalisant toutes les fonctions de l'organe fonctionnel (principalement fonctions de commutation et de visualisation), l'utilisateur peut ainsi y adapter une interface de dialogue homme-machine comprenant une interface de commande et/ou une interface de visualisation. Le système de l'invention est expliqué en détail ci-dessous.

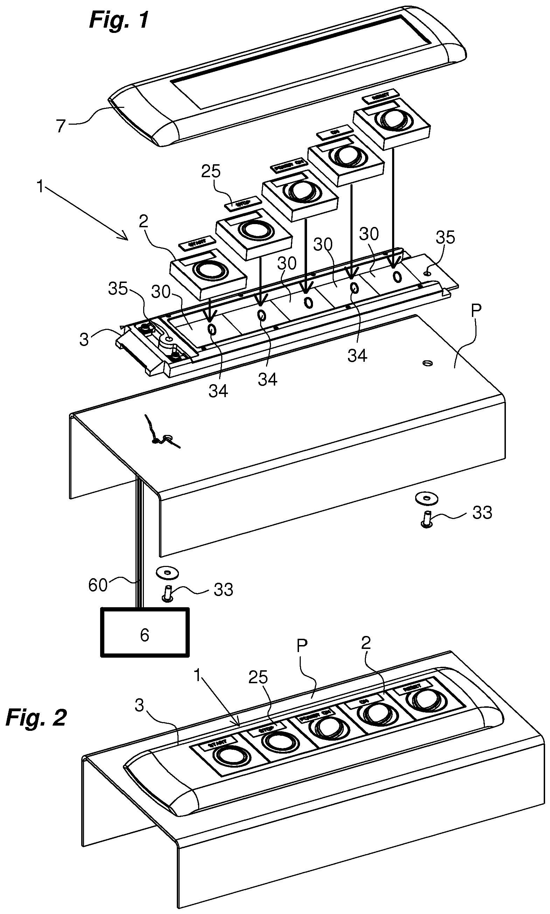

Selon l'invention, en référence à la figure 1, le système 1 de dialogue homme-machine comporte un support 3, réalisé par exemple en matière plastique et comprenant une face inférieure et une face supérieure. Le support 3 est par exemple destiné à se fixer par sa face inférieure sur une paroi P, par exemple la paroi d'une armoire électrique ou d'un pupitre de commande. Le support 3 comporte par exemple des moyens de fixation pour se fixer sur ladite paroi P. Lesdits moyens de fixation comportent par exemple deux orifices 35 destinés à recevoir chacun l'extrémité d'une vis 33 traversant ladite paroi P.

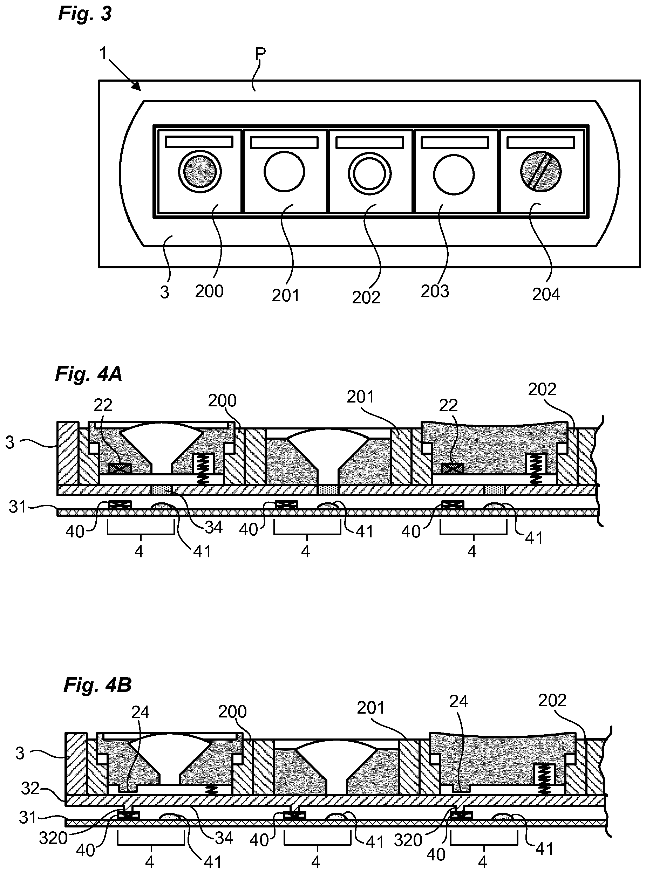

Selon l'invention, le support 3 comporte plusieurs postes d'accueil 30, préférentiellement identiques (délimités de manière artificielle par des traits sur la figure 1), agencés sur une plage ou surface d'accueil du support. Les postes d'accueil 30 sont chacun associés à un dispositif universel 4 de dialogue homme-machine identique (visibles sur les figures 4A et 4B). Le dispositif universel 4 de dialogue homme-machine est apte à réaliser la fonction de commutation et la fonction de visualisation décrites ci-dessus. Plus précisément, chaque dispositif universel 4 de dialogue homme-machine comporte donc au moins un organe capteur 40 chargé de réaliser la fonction de commutation et un organe de visualisation 41 chargé de réaliser la fonction de visualisation. Sur chaque poste d'accueil 30, toutes les fonctions sont donc réalisées de manière à permettre à un utilisateur de pouvoir y ajouter l'interface de dialogue homme-machine de son choix.

Selon l'invention, les postes d'accueil 30 sont formés dans le support 3 et consistent en plusieurs logements de formes identiques. Sur les figures annexées, les logements sont réalisés de manière contigüe de manière à former la plage ou surface d'accueil décrite ci-dessus. Le support 3 intègre une ou plusieurs cartes électroniques supportant les dispositifs universels 4 de dialogue homme-machine. Sur les figures 4A et 4B, une seule carte électronique 31 est employée et celle-ci s'étend à l'intérieur du support 3, sous les postes d'accueil 30. Les dispositifs universels 4 de dialogue homme-machine sont soudés sur la carte électronique 31, en vis-à-vis de chaque poste d'accueil 30. Au niveau de chaque poste d'accueil 30, le support 3 comporte ainsi une ouverture réalisée en vis-à-vis de l'organe de visualisation 41 du dispositif universel 4 de dialogue homme-machine, chaque ouverture étant par exemple fermée par un hublot 34 translucide ou transparent de manière à garantir l'étanchéité de l'espace interne du support incluant la carte électronique 30 par rapport à l'extérieur. Selon la technologie employée pour réaliser l'organe capteur 40, le support 3 présentera une architecture adaptée.

Selon l'invention, le système 1 de dialogue homme-machine comporte également une pluralité d'organes modulaires 2 comprenant chacun uniquement une interface de dialogue homme-machine telle que décrite ci-dessus. Un organe modulaire 2 ne comporte ni carte électronique, ni organe fonctionnel de commutation ou de visualisation. Il est indépendant par rapport son organe fonctionnel.

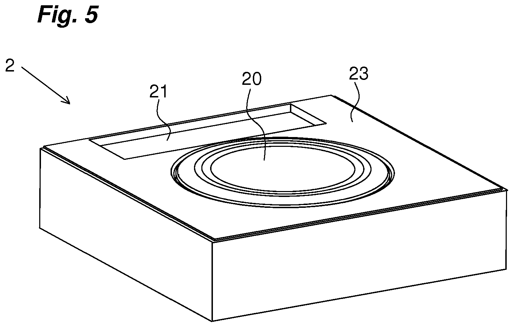

Selon l'invention, chaque organe modulaire 2 vient occuper un poste d'accueil 30 du support 3. En référence à la figure 5, un organe modulaire 2 comporte un boîtier 23, par exemple en matière plastique, agencé pour se loger et épouser la forme d'un logement du support 3. Il comporte également une interface de dialogue homme-machine 20 (par exemple un bouton poussoir sur la figure 5) et peut comporter un emplacement 21 pour positionner une étiquette 25 de désignation de l'organe. Selon l'invention, l'interface de dialogue homme-machine est destinée à coopérer avec un dispositif universel 4 de dialogue homme-machine tel que décrit ci-dessus. Selon le type d'organe modulaire 2 positionné sur un poste d'accueil 30 du support, l'interface de dialogue homme-machine 20 coopère avec l'organe capteur 40 et/ou avec l'organe de visualisation 41.

La figure 3 représente un exemple d'architecture d'un système de dialogue homme-machine de l'invention. Ce système comporte, à un premier poste d'accueil 30, un premier organe modulaire 200 comprenant une interface de commande de type bouton poussoir et une interface de visualisation, à un deuxième poste d'accueil, un deuxième organe modulaire 201 présentant seulement une interface de visualisation, à un troisième poste d'accueil, un troisième organe modulaire 202 présentant seulement une interface de commande de type bouton-poussoir, à un quatrième poste d'accueil, un quatrième organe modulaire 203 présentant une autre interface de visualisation et à un cinquième poste d'accueil, un cinquième organe modulaire 204 présentant une interface de commande de type bouton tournant.

Les figures 4A et 4B représentent de manière partielle et vu en coupe le système de dialogue homme-machine illustré sur la figure 3 (seuls trois organes modulaires sont représentés). Sur la figure 4A, l'interface de visualisation du premier organe modulaire 200 est placé en vis-à-vis de l'organe de visualisation 41 du dispositif universel de dialogue homme-machine du premier poste d'accueil et l'interface de commande coopère avec l'organe capteur 40 du dispositif de dialogue homme-machine associé au premier poste d'accueil. L'interface de visualisation du deuxième organe modulaire 201 est placée en vis-à-vis de l'organe de visualisation 41 du dispositif universel de dialogue homme-machine associé au deuxième poste d'accueil. L'organe capteur 40 de ce dispositif universel de dialogue homme-machine ne sert pas pour le deuxième organe modulaire 201. L'interface de commande du troisième organe modulaire 202 coopère avec l'organe capteur 40 du dispositif universel de dialogue homme-machine associé au troisième poste d'accueil. L'organe de visualisation 41 du dispositif universel ne sert pas pour le troisième organe modulaire 202.

Selon l'invention, l'interface de commande du premier organe modulaire 200 et du troisième organe modulaire 202 comporte par exemple un aimant permanent 22 (figure 4A) actionnable en mouvement pour agir sur l'organe capteur 40. L'organe capteur 40 comporte ainsi un capteur à effet hall ou un micro-interrupteur à actionnement magnétique de type MEMS ou reed. L'organe capteur 40 peut être à actionnement monostable ou bistable. Aucune liaison mécanique n'étant présente entre l'organe modulaire 2 et le dispositif universel 4 de dialogue homme-machine, la commande par effet magnétique présente des avantages en termes d'étanchéité et de résistance à l'usure.

En variante de réalisation, l'organe capteur 40 peut également comporter un interrupteur à actionnement mécanique. En référence à la figure 4B, le support comporte ainsi une membrane souple 32, formant sur le support, la surface d'accueil des organes modulaires, ladite membrane souple 32 étant positionnée juste au-dessus de la carte électronique 31 portant l'organe capteur 40. En vis-à-vis de chaque organe capteur 40, la membrane souple 32 présente un poussoir 320 agencé sous ladite membrane souple 32, sur la face inférieure de celle-ci, de manière à pouvoir coopérer mécaniquement avec l'organe capteur 40. L'interface de commande d'un organe modulaire (par exemple organes modulaires 200 et 202 sur la figure 4B) comporte par exemple un élément d'actionnement 24 agencé pour coopérer avec la membrane souple 32, sur la face supérieure de celle-ci. Lors d'une action sur l'interface de commande, l'élément d'actionnement 24 appuie sur la membrane souple 32. Grâce à sa flexibilité, la membrane souple 32 entraîne en translation son poussoir 320 qui vient appuyer sur l'organe capteur situé au-dessous. Bien entendu, d'autres agencements mécaniques pourraient être envisagés. Bien entendu, il faut comprendre que l'architecture représentée sur la figure 3 et les figures 4A et 4B n'est qu'un exemple. L'interface de commande pourrait être de tout autre type et employer un bouton tournant ou une autre solution adaptée pour coopérer avec l'organe capteur 40. De même, l'organe capteur 40 pourrait être d'un autre type, et employer d'autres solutions de détection à effet résistif, optique, capacitif... L'organe modulaire chargé de coopérer avec de tels organes capteurs aura alors une architecture adaptée pour faire fonctionner cet organe capteur 40.

Selon l'invention, les organes modulaires 2 sont positionnés dans le support 3 de manière amovible et interchangeable. Les organes modulaires 2 peuvent être aisément permutés dans le système ou peuvent être chacun remplacés facilement en cas de panne ou en cas d'évolution de sa commande. Selon l'invention, le boîtier 23 des organes modulaires est préférentiellement de forme carrée, ce qui leur permet de pouvoir prendre deux orientations distinctes, décalées entre elles de 90°. Le support pourra ainsi être fixé dans un même plan selon deux orientations, décalées entre elles de 90°.

Plusieurs architectures peuvent être envisagées pour maintenir les organes modulaires dans le système.

Une première architecture consiste à positionner les organes modulaires 2 dans le support 3 puis à les maintenir par un capot 7 venant se positionner sur le support (figure 1).

Une deuxième architecture (non représentée) consiste par exemple à positionner un capot sur le support puis à doter le support et les organes modulaires de moyens de fixation rapide dans le capot ou le support, par exemple des moyens d'encliquetage. Bien entendu, d'autres configurations de fixation pourraient être envisagées.

Selon l'invention, les dispositifs universels 4 de dialogue homme-machine intégrés au support sont raccordés à une unité centrale de commande 6 (figure 1) par une liaison point à point ou par une liaison multipoints. L'unité centrale de commande 6 assure l'alimentation et le transfert de données vers chaque dispositif universel 4 de dialogue homme-machine. L'unité centrale de commande pourra être intégrée au système ou réalisée dans un dispositif séparé. L'unité centrale peut donc envoyer un ordre de commande, individuellement, à chaque organe de visualisation 41 d'un dispositif universel 4 de dialogue homme-machine et recevoir un signal de commande de chaque organe capteur 40 des dispositifs universels 4 de dialogue homme-machine qui lui sont connectés.

En liaison point à point, chaque dispositif universel 4 est donc connecté de manière indépendante à l'unité centrale de commande 6. Le support 3 intègre donc une nappe de fils connectée à l'unité centrale de commande 6. Dans cette configuration, une configuration de l'unité centrale de commande est nécessaire pour l'informer du type de d'organe modulaire placé en vis-à-vis des postes d'accueil 30.

En liaison multipoints, les dispositifs universels 4 de dialogue homme-machine sont connectés à l'unité centrale de commande 6 par l'intermédiaire d'un bus de communication et d'alimentation agencé à l'intérieur du support 3, par exemple sur la carte électronique 31 supportant les dispositifs universels 4 de dialogue homme-machine. Un protocole de communication est donc nécessaire pour assurer la communication entre l'unité centrale de commande 6 et les dispositifs universels 4 de dialogue homme-machine. En multipoints, chaque signal de commande envoyé par l'unité centrale de commande 6 ou reçu par celle-ci doit comporter l'identifiant du dispositif universel 4 de dialogue homme-machine destinataire ou expéditeur. Le protocole de communication est par exemple un protocole à deux fils permettant de faire passer à la fois l'alimentation des dispositifs universels 4 de dialogue homme-machine et les trames de communication échangées entre chaque dispositif universel 4 de dialogue homme-machine et l'unité centrale de commande 6. Un protocole de ce type déjà connu est celui dénommé "OneWire" (appelé également protocole DALLAS) décrit à l'adresse suivante : http://daniel.menesplier.free.fr/Doc/BUS%201%20WIRE.pdf
Dans une architecture à bus de communication, une étape d'apprentissage sera nécessaire afin d'informer l'unité centrale de commande 6 du type d'organe modulaire 2 présent à chaque poste d'accueil 30, de manière à ce que l'unité centrale de commande 6 assure une commande adaptée des dispositifs universels 4 de dialogue homme-machine.

Selon l'invention, l'unité centrale de commande 6 peut être intégrée au support 3, déportée en partie ou totalement par rapport audit support. Sur la figure 1, l'unité centrale de commande 6 est représentée déportée par rapport au support 3 et reliée aux dispositifs universels 4 de dialogue homme-machine par l'intermédiaire d'un câble 60 assurant l'alimentation et le transfert de données. Sur la figure 1, le câble 60 traverse la paroi P et vient se connecter sur des bornes prévues à l'intérieur du support 3 et destinées à être masquées par le capot 7.

De manière avantageuse, le système de dialogue homme-machine sera adapté pour mettre en oeuvre la fonction arrêt d'urgence. Pour cela, le support 3 intègrera un organe capteur adapté à réaliser cette fonction, cet organe capteur étant relié à l'unité centrale de commande 6 par une liaison sécurisée. L'organe capteur pourra être associée à un poste d'accueil 30 déterminé, destiné à recevoir un organe spécifique présentant une interface de commande de type arrêt d'urgence. En variante de réalisation cet organe spécifique pourra être intégré au support 3, associé à son organe capteur.

Selon une variante de réalisation, chaque organe modulaire 2 peut intégrer une étiquette électronique mémorisant un identifiant et la fonction de l'organe modulaire. Il s'agit par exemple d'une étiquette de type RFID. Une station de lecture (par exemple intégrée à l'unité centrale de commande 6) comprenant une antenne intégrée au support 3, permet ainsi de détecter les postes d'accueil 30 occupés et de déterminer la fonction de chaque organe modulaire 2 occupant un poste d'accueil. Cette architecture permet ainsi de s'affranchir de l'étape d'apprentissage.

Selon une variante de réalisation, le système peut comporter un module de communication sans-fil permettant d'échanger des signaux avec l'unité centrale de commande 6 à travers une liaison sans-fil. La communication pourra être réalisée par exemple par ondes radio via des protocoles connus de type WIFI, Bluetooth... Les données échangées comportent notamment les ordres de commande émis par chaque organe capteur et/ou les ordres d'allumage ou d'extinction émis par l'unité centrale de commande 6 à destination des organes de visualisation. Ce module de communication peut comporter un émetteur/récepteur centralisé, intégré au support 3 et chargé d'échanger des données avec l'unité centrale de commande 6. Il peut également comporter plusieurs émetteurs/récepteurs distincts associés chacun à un dispositif universel 4 de dialogue homme-machine.

L'invention consiste donc à désolidariser les fonctions de commutation et de visualisation, réalisées par l'organe capteur et par l'organe de visualisation, de l'interface de commande et/ou de visualisation. En proposant d'employer des dispositifs universels de dialogue homme-machine embarquant les deux fonctions, il est ainsi possible de s'affranchir de contraintes de positionnement des organes modulaires, de facilement choisir sa configuration et de la modifier.

Le système 1 de dialogue homme-machine de l'invention présente donc les avantages suivants :
- il permet à un opérateur de choisir ou d'adapter sa configuration, en fonction de l'application commandée,
- il permet de remplacer aisément un organe modulaire par un autre,
- il est facile à installer, en ce qu'il ne nécessite que deux trous de fixation pour le support et un trou pour le passage du câble,
- il permet de proposer des organes modulaires à un coût modéré, ceux-ci n'embarquant aucune carte électronique,
- la carte électronique étant logée à l'intérieur du support, il est aisé d'assurer son isolation par rapport à l'extérieur et de garantir un bon niveau d'étanchéité,
- il est peu encombrant,
- il peut se fixer selon deux orientations distinctes, décalées entre elles de 90°.

## Revendications

1. Système (1) de dialogue homme-machine, comprenant:
- un support (3) comportant une pluralité de postes d'accueil (30) identiques, chaque poste d'accueil (30) étant associé à un dispositif universel (4) de dialogue homme-machine, chaque dispositif universel (4) de dialogue homme-machine comprenant au moins un organe de visualisation (41) et un organe capteur (40),
- une pluralité d'organes modulaires (2), chaque organe modulaire (2) étant agencé pour se positionner sur un poste d'accueil (30) de manière amovible et interchangeable et comprenant une interface de dialogue homme-machine (20) agencée pour coopérer avec ledit organe de visualisation (41) et/ou ledit organe capteur (40), ladite pluralité d'organes modulaires comportant un premier organe modulaire positionné sur un premier poste d'accueil et dont l'interface de dialogue homme-machine (20) est uniquement une interface de commande et un deuxième organe modulaire positionné à un deuxième poste d'accueil et dont l'interface de dialogue homme-machine est uniquement une interface de visualisation,
le système étant **caractérisé en ce qu'**il comprend
- une unité centrale de commande agencée pour communiquer sélectivement avec l'organe de visualisation et/ou l'organe capteur de chaque poste d'accueil selon le type d'interface de dialogue homme/machine de l'organe modulaire positionné sur chaque poste d'accueil, ladite unité centrale de commande étant agencée pour recevoir un signal de commande de l'organe capteur (40) du premier poste d'accueil lorsque l'interface de commande du premier organe modulaire est activée et pour envoyer un ordre de commande à l'organe de visualisation (41) du deuxième poste d'accueil pour activer l'interface de visualisation du deuxième organe modulaire.

2. Système selon la revendication 1, **caractérisé en ce que** l'interface de commande comporte un bouton d'actionnement.

3. Système selon la revendication 2, **caractérisé en ce que** l'organe capteur comporte un interrupteur à actionnement magnétique.

4. Système selon la revendication 3, **caractérisé en ce que** le bouton d'actionnement porte au moins un aimant permanent (22) actionnable en mouvement pour agir sur l'interrupteur à actionnement magnétique.

5. Système selon la revendication 2, **caractérisé en ce que** l'organe capteur (40) comporte un interrupteur à actionnement mécanique.

6. Système selon la revendication 5, **caractérisé en ce que** le bouton d'actionnement comporte un élément d'actionnement (24) agencé pour coopérer avec l'interrupteur à actionnement mécanique.

7. Système selon la revendication 1, **caractérisé en ce que** l'organe capteur est à effet capacitif, inductif, optique ou résistif.

8. Système selon la revendication 1, **caractérisé en ce que** le support (3) comporte des moyens de fixation sur une paroi et **en ce que** ces moyens de fixation comportent deux orifices (35) destinés à recevoir chacun une vis de fixation (33).

9. Système selon la revendication 1, **caractérisé en ce qu'**il comporte une unité centrale de commande (6) et un câble (60) reliant ladite unité centrale de commande (6) aux dispositifs universels (4) de dialogue homme-machine, ladite unité centrale de commande (6) étant agencée pour alimenter chaque dispositif universel (4) de dialogue homme-machine et échanger des signaux avec chaque dispositif universel (4) de dialogue homme-machine.

10. Système selon la revendication 9, **caractérisé en ce que** les dispositifs universels (4) de dialogue homme-machine sont connectés à l'unité centrale par une liaison multipoints en employant un bus de communication et d'alimentation.

11. Système selon la revendication 9, **caractérisé en ce que** les dispositifs universels (4) de dialogue homme-machine sont connectés à l'unité centrale par une liaison point à point.

12. Système selon la revendication 1, **caractérisé en ce que** chaque organe modulaire comporte une étiquette électronique mémorisant le type d'interface de dialogue homme-machine (20) de l'organe modulaire auquel elle est associée.

13. Système selon la revendication 12, **caractérisé en ce qu'**il comporte une station de lecture des étiquettes électroniques qui sont intégrées dans chaque organe modulaire (2), ladite station de lecture comportant une antenne agencée à l'intérieur du support (3).

14. Système selon la revendication 9, **caractérisé en ce qu'**il comporte un module de communication sans-fil agencé pour échanger des données avec l'unité centrale de commande (6) via une liaison sans-fil.

15. Système selon la revendication 1, **caractérisé en ce que** les postes d'accueil (30) sont agencés de manière contigüe sur le support.

16. Système selon la revendication 1, **caractérisé en ce que** les organes modulaires (2) sont solidarisés au support à l'aide d'un capot (7) rapporté sur le support (3).

17. Système selon la revendication 1, **caractérisé en ce que** les organes modulaires (2) sont solidarisés au support en employant des moyens d'encliquetage.

18. Système selon la revendication 1, **caractérisé en ce que** chaque organe modulaire comporte un boîtier (23) de forme carrée sur lequel est montée ladite interface de dialogue homme-machine (20).

## Patentansprüche

1. Mensch-Maschinen-Dialogsystem (1), umfassend:
- eine Träger (3), der mehrere identische Aufnahmestellen (30) aufweist, wobei jede Aufnahmestelle (30) einer universellen Mensch-Maschine-Dialogvorrichtung (4) zugeordnet ist, wobei jede universelle Mensch-Maschine-Dialogvorrichtung (4) mindestens ein Anzeigeorgan (41) und ein Sensororgan (40) aufweist,
- mehrere modulare Organe (2), wobei jedes modulare Organ (2) ausgebildet ist, um auf einer Aufnahmestelle (30) abnehmbar und austauschbar angeordnet zu werden, und eine Mensch-Maschine-Dialogschnittstelle (20) aufweist, die ausgebildet ist, um mit dem Anzeigeorgan (41) und/oder dem Sensororgan (40) zusammenwirken, wobei die mehreren modularen Organe ein erstes modulares Organ, das auf einer ersten Aufnahmestelle angeordnet ist und dessen Mensch-Maschine-Dialogschnittstelle (20) nur eine Steuerschnittstelle ist, und ein zweites modulares Organ aufweisen, das an einer zweiten Aufnahmestelle angeordnet ist und dessen Mensch-Maschine-Dialogschnittstelle nur eine Anzeigeschnittstelle ist,
wobei das System **dadurch gekennzeichnet ist, dass** es aufweist
- eine zentrale Steuereinheit, die ausgebildet ist, um selektiv mit dem Anzeigeorgan und/oder dem Sensororgan jeder Aufnahmestelle abhängig vom Typ der Mensch-Maschine-Dialogschnittstelle des modularen Organs, das auf jeder Aufnahmestelle angeordnet ist, zu kommunizieren, wobei die zentrale Steuereinheit ausgebildet ist, um ein Steuersignal von dem Sensororgan (40) der ersten Aufnahmestelle zu empfangen, wenn die Steuerschnittstelle des ersten modularen Organs aktiviert ist, und um einen Steuerbefehl an das Anzeigeorgan (41) der zweiten Aufnahmestelle zu senden, um die Anzeigeschnittstelle des zweiten modularen Organs zu aktivieren.

2. System nach Anspruch 1, **dadurch gekennzeichnet, dass** die Steuerschnittstelle einen Betätigungsknopf aufweist.

3. System nach Anspruch 2, **dadurch gekennzeichnet, dass** das Sensororgan einen magnetisch betätigbaren Schalter aufweist.

4. System nach Anspruch 3, **dadurch gekennzeichnet, dass** der Betätigungsknopf mindestens einen Permanentmagneten (22) trägt, der in Bewegung betätigbar ist, um auf den magnetisch betätigbaren Schalter einzuwirken.

5. System nach Anspruch 2, **dadurch gekennzeichnet, dass** das Sensororgan (40) einen mechanisch betätigbaren Schalter aufweist.

6. System nach Anspruch 5, **dadurch gekennzeichnet, dass** der Betätigungsknopf mindestens ein Betätigungselement (24) aufweist, das ausgebildet ist, um mit dem mechanisch betätigbaren Schalter zusammenzuwirken.

7. System nach Anspruch 1, **dadurch gekennzeichnet, dass** das Sensororgan mit kapazitiver, induktiver, optischer oder resistiver Wirkung ist.

8. System nach Anspruch 1, **dadurch gekennzeichnet, dass** der Träger (3) Mittel zum Befestigen an einer Wand aufweist und dadurch, dass diese Mittel zum Befestigen zwei Öffnungen (35) aufweisen, die dazu bestimmt sind, jeweils eine Befestigungsschraube (33) aufzunehmen.

9. System nach Anspruch 1, **dadurch gekennzeichnet, dass** es eine zentrale Steuereinheit (6) und ein Kabel (60) aufweist, das die zentrale Steuereinheit (6) mit den universellen Mensch-Maschine-Dialogvorrichtungen (4) verbindet, wobei die zentrale Steuereinheit (6) ausgebildet ist, um jede universelle Mensch-Maschine-Dialogvorrichtung (4) mit Strom zu versorgen und Signale mit jeder universellen Mensch-Maschine-Dialogvorrichtung (4) auszutauschen.

10. System nach Anspruch 9, **dadurch gekennzeichnet, dass** die universellen Mensch-Maschine-Dialogvorrichtungen (4) durch eine Mehrpunktverbindung an die zentrale Einheit angeschlossen sind, indem ein Kommunikation- und Versorgungsbus verwendet wird.

11. System nach Anspruch 9, **dadurch gekennzeichnet, dass** die universellen Mensch-Maschine-Dialogvorrichtungen (4) durch eine Punkt-zu-Punkt-Verbindung an die zentrale Einheit angeschlossen sind.

12. System nach Anspruch 1, **dadurch gekennzeichnet, dass** jedes modulare Organ ein elektronisches Etikett aufweist, das den Typ der Mensch-Maschine-Dialogschnittstelle (20) des modularen Organs speichert, dem es zugeordnet ist.

13. System nach Anspruch 12, **dadurch gekennzeichnet, dass** es eine Lesestation der elektronischen Etikette aufweist, die in jedem modularen Organ (2) integriert sind, wobei die Lesestation eine Antenne aufweist, die im Inneren des Trägers (3) angeordnet ist.

14. System nach Anspruch 9, **dadurch gekennzeichnet, dass** es ein drahtloses Kommunikationsmodul aufweist, das ausgebildet ist, um Daten mit der zentralen Steuereinheit (6) über eine drahtlose Verbindung auszutauschen.

15. System nach Anspruch 1, **dadurch gekennzeichnet, dass** die Aufnahmestellen (30) auf dem Träger aneinandergrenzend ausgebildet sind.

16. System nach Anspruch 1, **dadurch gekennzeichnet, dass** die modularen Orange (2) mit Hilfe von einer Haube (7), die auf dem Träger (3) angebracht ist, an dem Träger fest verbunden sind.

17. System nach Anspruch 1, **dadurch gekennzeichnet, dass** die modularen Orange (2) durch Verwenden von Rastmitteln an dem Träger fest verbunden sind.

18. System nach Anspruch 1, **dadurch gekennzeichnet, dass** jedes modulare Organ ein Gehäuse (23) von quadratischer Form aufweist, auf dem die Mensch-Maschine-Dialogschnittstelle (20) befestigt ist.

## Claims

1. Human-machine dialog system (1), comprising:
- a support (3) having a plurality of identical docking stations (30), each docking station (30) being associated with a universal human-machine dialog device (4), each universal human-machine dialog device (4) comprising at least a display member (41) and a sensor member (40),
- a plurality of modular members (2), each modular member (2) being arranged to be positioned in a docking station (30) in a removable and interchangeable manner and comprising a human-machine dialog interface (20) arranged to cooperate with said display member (41) and/or said sensor member (40), said plurality of modular members including a first modular member positioned in a first docking station and whose human-machine dialog interface (20) is a control interface and a second modular member positioned in a second docking station and whose human-machine dialog interface is a display interface,
the system being **characterized in that** it comprises:
- a central control unit arranged to communicate selectively with the display member and/or the sensor member of each docking station, according to the type of human/machine dialog interface of the modular member positioned on each docking station, said central control unit being arranged to receive a control signal from the sensor member (40) of the first docking station when the control interface of the first modular member is activated and to send a control order to the display member (41) of the second docking station to activate the display interface of the second modular member.

2. System according to Claim 1, **characterized in that** the control interface has an activation button.

3. System according to Claim 2, **characterized in that** the sensor member has a switch with magnetic action.

4. System according to Claim 3, **characterized in that** the activation button bears at least one permanent magnet (22) that can be activated by movement to act on the switch with magnetic action.

5. System according to Claim 2, **characterized in that** the sensor member (40) has a switch with mechanical action.

6. System according to Claim 5, **characterized in that** the activation button has an activation element (24) arranged to cooperate with the switch with mechanical action.

7. System according to Claim 1, **characterized in that** the sensor member has a capacitive, inductive, optical or resistive effect.

8. System according to Claim 1, **characterized in that** the support (3) has means for fastening it to a wall and **in that** these fastening means have two orifices (35), each intended to receive a fastening screw (33).

9. System according to Claim 1, **characterized in that** it has a central control unit (6) and a cable (60) linking said central control unit (6) to the universal human-machine dialog devices (4), said central control unit (6) being arranged to supply power to each universal human-machine dialog device (4) and exchange signals with each universal human-machine dialog device (4).

10. System according to Claim 9, **characterized in that** the universal human-machine dialog devices (4) are connected to the central unit by a multipoint link using a communication and power supply bus

11. System according to Claim 9, **characterized in that** the universal human-machine dialog devices (4) are connected to the central unit by a point-to-point link.

12. System according to Claim 1, **characterized in that** each modular member has an electronic tag storing in its memory the type of human-machine dialog interface (20) of the modular member with which it is associated.

13. System according to Claim 12, **characterized in that** it has a station for reading the electronic tags that are incorporated into each modular member (2), said reading station having an antenna arranged inside the support (3).

14. System according to Claim 9, **characterized in that** it has a wireless communication module arranged to exchange data with the central control unit (6) via a wireless link.

15. System according to Claim 1, **characterized in that** the docking stations (30) are arranged in a contiguous manner on the support.

16. System according to Claim 1, **characterized in that** the modular members (2) are joined to the support using a cover (7) attached to the support (3).

17. System according to Claim 1, **characterized in that** the modular members (2) are joined to the support using clipping means.

18. System according to Claim 1, **characterized in that** each modular member has a square-shaped housing (23) in which said human-machine dialog interface (20) is mounted.
